# EUROPEAN PATENT SPECIFICATION

(11) **EP 3 537 242 B1**
(45) Date of publication and mention of the grant of the patent: **01.04.2020**
(21) Application number: 18212224.2
(22) Date of filing: 13.12.2018
(51) Int. Cl.: G05B 19/042

(54) **DIGITAL FILTER SETTING DEVICE, CONTROL METHOD OF DIGITAL FILTER SETTING DEVICE AND CONTROL PROGRAM**
VORRICHTUNG ZUR EINSTELLUNG VON DIGITALEN FILTERN, STEUERUNGSVERFAHREN FÜR EINE VORRICHTUNG ZUR EINSTELLUNG VON DIGITALEN FILTERN UND STEUERUNGSPROGRAMM
DISPOSITIF DE RÉGLAGE DE FILTRE NUMÉRIQUE, PROCÉDÉ DE COMMANDE D'UN DISPOSITIF DE RÉGLAGE DE FILTRE NUMÉRIQUE ET PROGRAMME DE COMMANDE

(30) Priority: 08.03.2018 JP 2018042113
(43) Date of publication of application: 11.09.2019
(73) Proprietor: OMRON Corporation, Shiokoji-dori, Shimogyo-Ku Kyoto-shi Kyoto 600-8530 (JP)
(72) Inventor: HIGA, Yoshinori, KYOTO, 600-8530 (JP); IWAMURA, Shintaro, KYOTO, 600-8530 (JP)
(74) Representative: 2K Patentanwälte Blasberg Kewitz & Reichel

(56) References cited:
- US-A1- 2014 137 069

## Description

### BACKGROUND

### Technical Field

The invention relates to a digital filter setting device which sets parameters of a digital filter and so on.

### Related Art

A digital filter processing device which eliminates an electrical noise, a mechanical vibration noise and the like included in an analog input signal and stabilizes the analog signal by performing a digital filter processing to the analog input signal is known. In the digital filter processing device, the analog signal can be stabilized by executing multiple digital filter processing. However, the more the digital filter processing is, the longer the step response time is, resulting in a delay of rising of the analog signal after the digital filter processing.

Therefore, it is desirable that a relation between parameters and the step response time or the like of the digital filter can be recognized in advance. However, so far, a user refers to a manual to calculate an operation cycle of the digital filter and performs parameter tuning of the digital filter when setting the parameters of the digital filter.

Besides, for example, described in patent literature 1 is a setting assistance device which assists in easily and appropriately setting a plurality of control parameters. In the setting assistance device described in patent literature 1, a value of at least one of the control parameters is changed to perform a simulation using a virtual model and calculate a performance index of a control object.

In addition, a technology related to an optimal design assistance device for a feed drive system of a multi-spindle machine tool is described in patent literature 2. In addition, an example of performing parameter input, a transient analysis processing, an AC analysis processing and a filter effect analysis processing in the simulation is described in patent literature 3.
Patent literature 4 discloses method according to an embodiment of a filter design tool is provided and includes receiving filter parameters for an analog filter through a user interface, where the filter parameters include an optimization parameter related to an application requirement of the analog filter, optimizing the filter for the optimization parameter, calculating a design output based on the optimized filter, and displaying the design output on the user interface. The method can further include receiving viewing parameters that specify the design output to be displayed. In various embodiments, the user interface includes an input area, a viewing area and a window area in one or more pages, where the input area is contiguous to the viewing area in at least one page. The filter parameters can be entered in the input area and the design output is calculated and displayed in the contiguous viewing area substantially immediately.

### [Literature of related art]

### [Patent literature]

[Patent literature 1] Japanese Patent Application Laid-open No. 2017-167607 (disclosed on September 21, 2017)
[Patent literature 2] Japanese Patent Application Laid-open No. 2008-102714 (disclosed on May 1, 2008)
[Patent literature 3] Japanese Patent Application Laid-open No. 2014-182734 (disclosed on September 29, 2014)
[Patent literature 4] US Patent Application US 2014/137069 A1.

### SUMMARY

### [Problems to be solved]

As described above, it is desirable that a relation between parameters and a step response time or the like of a digital filter can be recognized in advance. However, in order to calculate the step response time, it is necessary to grasp a digital filter operation cycle and the like but a formula thereof is complex. Therefore, a user cannot easily calculate by using a manual and the like.

When the step response time is long, rising of an input analog signal is delayed. Accordingly, for example, in a programmable logic controller (PLC), when an I/O refresh timing is in the midway of the rising of the input analog signal, the input analog signal transmitted to a CPU unit or a communication coupler becomes a value in the midway of the rising.

In addition, the above-described patent literature 1 does not support the setting of the digital filter. In addition, in patent literatures 2 and 3, the setting of the digital filter is not described either.

One aspect of the invention is accomplished based on the above problems, and aims to realize a digital filter setting device or the like by which the filter characteristics of the digital filter after the parameter setting can be easily recognized by the user.

### [Means to Solve Problems]

In order to solve the above problems, the digital filter setting device of one aspect of the invention is a digital filter setting device which sets filter parameters of a digital filter device that performs a filter processing to an input analog signal by a digital filter, and the digital filter setting device includes: an input receiving part receiving input of the filter parameters; a filter characteristic calculation part calculating a step response time as a filter characteristic of the digital filter in a case that the filter parameters received by the input receiving part are set; and a graph display part displaying the calculated step response time in the form of graph on a display part.

According to the configuration, the step response time of the digital filter in a case of using the set filter parameters is displayed in the form of graph. Therefore, the user can recognize immediately the step response time of the digital filter in a case of using the filter parameters set by himself.

Accordingly, the user can easily recognize whether, at the step response time of the digital filter to which the filter parameters are set, rising of the analog signal after the filtering is delayed and an I/O refresh timing comes in the midway of the rising, for example, whether the analog signal transmitted to a CPU unit or a communication master which is an output destination becomes a value in the midway of the rising. Therefore, it can be prevented that the I/O refresh timing is in the midway of the rising of the analog signal and the analog input value transmitted to the CPU unit or the communication master becomes a value in the midway of the rising.

The digital filter setting device of one aspect of the invention is included in a control device which controls a control object by repeatedly executing a plurality of control programs at a prescribed time interval, and the graph display part may cause a task cycle of a fixed-cycle task in the control device to be displayed along with the graph on the display part.

According to the aforementioned configuration, the task cycle is displayed, and thus the user can easily recognize whether the step response time is within the task cycle.

In the digital filter setting device of one aspect of the invention, the filter characteristic calculation part calculates an attenuation characteristic of the digital filter as the filter characteristic, and the graph display part may display the attenuation characteristic of the digital filter in the form of graph.

According to the aforementioned configuration, the attenuation characteristic of the digital filter is displayed in the form of graph and thus the user can easily recognize the attenuation characteristic of the digital filter. Therefore, the user can confirm whether a change of the attenuation characteristic associated with parameter alteration is in a desired state.

The digital filter setting device of one aspect of the invention is capable of processing using plural kinds of digital filters, and the graph display part may display, in the form of graph, the filter characteristics of each of the plural kinds of digital filters or the filter characteristics in a combination of the plural kinds of digital filters.

According to the aforementioned configuration, the filter characteristics of the plural kinds of digital filters are displayed in the form of graph, and thus the user can easily recognize the filter characteristic of each digital filter or the filter characteristic of the combination of the digital filters. Therefore, the user can recognize a change degree of characteristics resulted from parameter alteration for each kind of the digital filters and thus can easily determine which parameter should be altered. In addition, a combined result is also displayed and thus the user can also easily recognize a final characteristic resulted from the parameter alteration.

In the digital filter setting device of one aspect of the invention, the filter parameters may include a cut-off frequency in a low-pass filter and a moving-average count in a moving-average filter.

According to the aforementioned configuration, the user can easily recognize the filter characteristics corresponding to the cut-off frequency in the low-pass filter and the moving-average count in the moving-average filter.

In order to solve the above problems, the control method of the digital filter setting device of one aspect of the invention is a control method of the digital filter setting device which sets filter parameters of a digital filter device for performing a filtering on an input analog signal by using a digital filter, and the control method of the digital filter setting device includes: an input receiving step for receiving input of the filter parameters; a filter characteristic calculation step for calculating a step response time as a filter characteristic of the digital filter in a case that the filter parameters received in the input receiving step are set; and a graph display step for displaying the calculated step response time in the form of graph on a display part.

According to the above method, the same effect as the above-described effect is exhibited.

The digital filter setting device of each aspect of the invention may be implemented by a computer; in this case, a control program of the digital filter setting device which implements the digital filter setting device with the computer by causing the computer to operate as each part (a software element) provided in the digital filter setting device, and a computer readable recording medium for recording the control program also fall into the range of the invention.

### [Effect]

According to one aspect of the invention, the step response time of the digital filter in a case of using the set filter parameters is displayed in the form of graph. Therefore, an effect is exhibited that the user can recognize immediately the step response time of the digital filter in a case of using the filter parameters set by himself.

### BRIEF DESCRIPTION OF THE DRAWINGS

FIG. 1 is a block diagram showing a main part configuration of a digital filter setting device of an embodiment of the invention.
FIG. 2 is a drawing schematically showing an example of a control system including the digital filter setting device.
FIG. 3 is a flowchart showing a processing flow in the digital filter setting device.
FIG. 4 is a drawing showing a screen example of the digital filter setting device.
FIG. 5 is a drawing showing a screen example in which filter parameters finally decided by a user are set in a high-speed analog unit.
FIG. 6 is a drawing showing an example of filter characteristics displayed by the digital filter setting device.
FIG. 7 is a drawing showing an example of filter characteristics displayed by the digital filter setting device.
FIG. 8 is a drawing showing an example of filter characteristics displayed by the digital filter setting device.

### DESCRIPTION OF THE EMBODIMENTS

### §1 Application Example

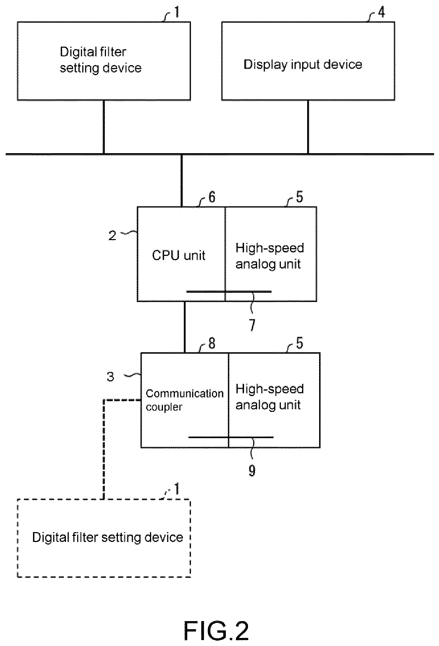

At first, with reference to FIG. 2, an example of a scene in which the invention is applied is described. FIG. 2 is a drawing schematically showing an example of a control system including a digital filter setting device 1 of the embodiment. As shown in FIG. 2, in the control system of the embodiment, in addition to the above-described digital filter setting device 1, a PLC (programmable logic controller) 2, an IO terminal 3 and a display input device 4 are included; the digital filter setting device 1, the PLC 2 and the display input device 4 are connected via a network, and the PLC 2 and the IO terminal 3 are also connected via a network.

Besides, as shown by a dotted line in FIG. 2, the digital filter setting device 1 and a communication coupler 8 of the IO terminal 3 may be directly connected, for example, by a USB (universal serial bus) cable and so on.

The digital filter setting device 1 is a device connected to a control system and used for setting the filter parameters of a digital filter processing in a high-speed analog unit (digital filter device) 5. An information processing device such as a computer may be used as the digital filter setting device 1, or a portable information processing device such as a notebook computer may be used.

The PLC 2 is a control device which controls a control object such as machinery and equipment, and controls the control object by repeatedly executing a plurality of control programs at a prescribed time interval. The PLC 2 is provided with a CPU unit 6 performing main operation processing and the high-speed analog unit 5, and the units in the PLC 2 are configured in a manner that data can be exchanged therebetween by a PLC system bus 7.

The high-speed analog unit 5 is a unit capable of performing a digital filter processing on an input analog signal and outputting the analog signal. The digital filter processing that can be executed by the high-speed analog unit 5 includes a processing using a low-pass filter, a processing using a moving-average filter, and a process using a combination of these filters. In the high-speed analog unit 5, by performing the digital filter processing on the input analog signal, noise components (electrical noise and mechanical vibration noise) included in the analog signal can be eliminated and a fluctuation of the analog input value can be suppressed, and the analog signal can be stabilized.

In addition, although not shown in the drawings, an input and output apparatus controlled by the PLC 2 may be connected to the high-speed analog unit 5. The input and output apparatus includes, for example, a "detector" such as a temperature sensor, an optical sensor or the like, an input apparatus such as a "switch (a push-button switch, a limit switch, a pressure switch or the like)", and an output apparatus such as a "actuator", a "relay", a "solenoid valve", a "display" and a "display lamp".

The IO terminal 3 includes the communication coupler 8 and the high-speed analog unit 5 for performing a processing related to data transmission. The communication coupler 8 and the high-speed analog unit 5 are configured to be capable of reciprocally exchanging data via an IO terminal bus 9.

The display input device 4 operates the PLC 2, confirms an operation state of the control system, and so on. The display input device 4 may be, for example, of a touch-panel type. In addition, the display input device 4 may function as the digital filter setting device 1.

As described above, in the embodiment, the setting of the filter parameters in the digital filter processing executed by the high-speed analog unit 5 is performed by the digital filter setting device 1. Besides, in the digital filter setting device 1, the filter characteristics (a step response time and an attenuation characteristic) of the digital filter in the set filter parameters are displayed in the form of graph on a display part 30 of the digital filter setting device 1. Accordingly, the user can recognize immediately whether the set filter parameters are appropriate by confirming the graph of filter characteristics. Therefore, the filter characteristics of the digital filter after the filter parameter setting can be easily recognized by the user.

### §2 Configuration Example

### [Configuration of digital filter setting device 1]

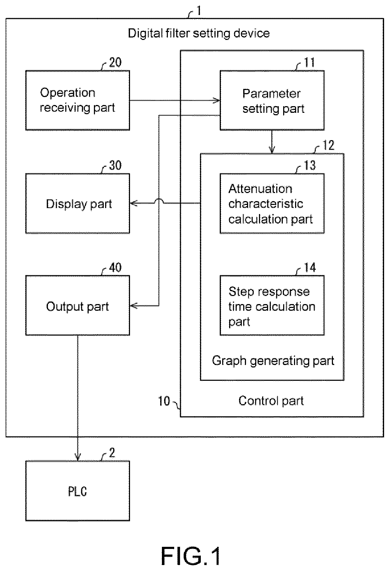

Next, with reference to FIG. 1, a main part configuration of the digital filter setting device 1 is described. FIG. 1 is a block diagram showing the main part configuration of the digital filter setting device 1. As shown in FIG. 1, the digital filter setting device 1 includes a control part 10, an operation receiving part 20, the display part 30, and an output part 40.

The control part 10 executes each processing in the digital filter setting device 1 including a processing for displaying the filter characteristics in the form of graph on the display part 30, and includes a parameter setting part (an input receiving part) 11 and a graph generating part (a graph display part) 12. In addition, the graph generating part 12 includes an attenuation characteristic calculation part (a filter characteristic calculation part) 13 and a step response time calculation part (a filter characteristic calculation part) 14.

The parameter setting part 11 sets the filter parameters in the digital filter processing executed by the high-speed analog unit 5. More specifically, the parameter setting part 11 notifies the graph generating part 12 of values of the filter parameters received via the operation receiving part 20, and sets final filter parameter values decided by the user to be the filter parameters of the digital filter executed by the high-speed analog unit 5 by outputting the final filter parameter values via the output part 40. The filter parameters include a sampling cycle, a cut-off frequency of the low-pass filter, a moving-average count of the moving-average filter, and so on.

The graph generating part 12 generates a graph showing the filter characteristics of the digital filter processing executed by the high-speed analog unit 5 using the filter parameters set by the parameter setting part 11, and displays the graph on the display part 30. More specifically, the graph generating part 12 includes the attenuation characteristic calculation part 13 and the step response time calculation part 14, generates a graph showing the attenuation characteristic calculated by the attenuation characteristic calculation part 13 and displays the graph on the display part 30, and generates a graph showing the step response time calculated by the step response time calculation part 14 and displays the graph on the display part 30. Besides, in the embodiment, although described as a configuration in which both the attenuation characteristic and the step response time are displayed, the invention is not limited thereto and may be configured to display any one of the two or may be configured to alternately display both.

The attenuation characteristic calculation part 13 calculates the attenuation characteristic in the digital filter processing executed by the high-speed analog unit 5 using the filter parameters notified from the parameter setting part 11. Besides, the calculation processing of the attenuation characteristic is specifically described later.

The step response time calculation part 14 calculates the step response time in the digital filter processing executed by the high-speed analog unit 5 using the filter parameters notified from the parameter setting part 11. Besides, the calculation processing of the step response time is specifically described later.

### [Processing flow of digital filter setting device 1]

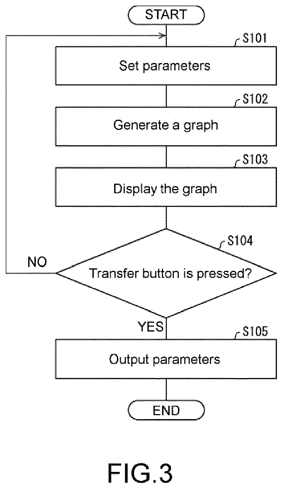

Next, with reference to FIG. 3, a processing flow of the digital filter setting device 1 is described. FIG. 3 is a flowchart showing the processing flow of the digital filter setting device 1. As shown in FIG. 3, first, the digital filter setting device 1 receives the setting of the filter parameters of the digital filter processing executed in the high-speed analog unit 5 (S101, an input receiving step). Next, the graph generating part 12 calculates the filter characteristics of the digital filter in the set filter parameters, generates a graph showing the filter characteristics (S102, a filter characteristic calculation step) and displays the graph on the display part 30 (S103, a graph display step).

Next, in the digital filter setting device 1, it is determined whether a transfer button is pressed (S104), and the processing proceeds to step S105 when the button is pressed ("YES" in S104) and returns to step S101 when the button is not pressed ("NO" in S104). This means the following situation. By the display of the graph of the filter characteristics in step S103, the user can confirm whether the filter characteristics are desirable, for example, whether the step response time is within the sampling cycle and an attenuation effect is exhibited. When it is determined that there is no problem as a result of the confirmation, the user presses the transfer button (corresponding to "YES" in step S104) and sets the set filter parameters to be the parameters of the digital filter of the high-speed analog unit 5. On the other hand, when it is determined that there is a problem, the user does not press the transfer button and resets the filter parameters (corresponding to a flow from "NO" in step S104 to step S101). Accordingly, the setting of the filter parameters is repeated and finally the filter parameters by which a desired effect is exhibited can be obtained.

In step S105, by outputting the set filter parameters to the high-speed analog unit 5, the parameters of the digital filter processing executed by the high-speed analog unit 5 are set.

As described above, the digital filter setting device 1 of the embodiment displays, in the form of graph, the filter characteristics (the step response time and the attenuation characteristic) of the digital filter used in the digital filter processing executed by the high-speed analog unit 5, and displays the task cycle of the fixed-cycle task executed by the PLC 2. Accordingly, the user can easily confirm whether the step response time is within the range of the task cycle.

The analog value can be more stabilized when more digital filter processing is executed, and thus it is desirable that the digital filter processing is executed as much as possible. However, the more the digital filter processing is executed, the longer the step response time is, resulting in the analog input value after the filter rising with a delay corresponding to the step response time.

Therefore, for example, an I/O refresh timing of the PLC system bus 7 of the PLC 2 may be in the midway of the rising of the analog input value after the filter; in this case, the analog input value transmitted to the CPU unit 6 or the communication coupler 8 becomes a value in the midway of the rising.

As described above, according to the embodiment, the user can easily confirm whether the step response time is within the range of the task cycle, and thus the user can easily confirm whether the above-described adverse effects occur. Therefore, the user can easily set the filter parameters and can execute an optimal digital filter processing in the high-speed analog unit 5 without the occurrence of the above-described adverse effects.

### [Screen example of digital filter setting device 1]

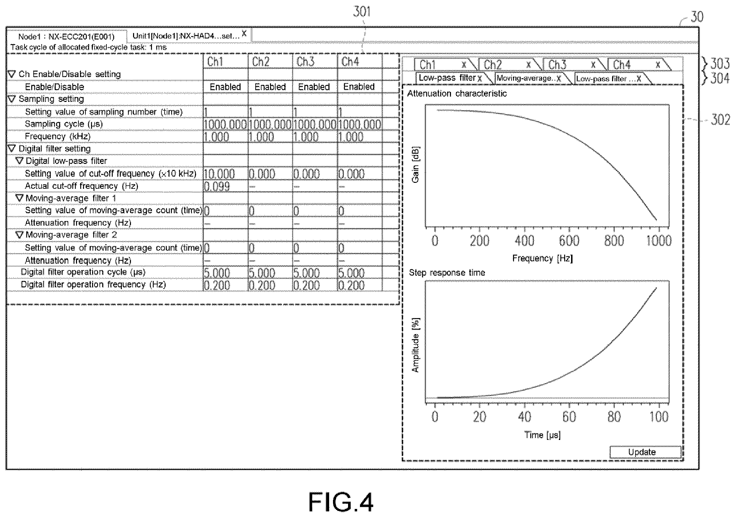

Next, with reference to FIG. 4, a screen example displayed on the display part 30 of the digital filter setting device 1 is described. FIG. 4 is a drawing showing the screen example of the digital filter setting device 1.

As shown in FIG. 4, on the display part 30 of the digital filter setting device 1, a setting screen of the filter parameters of the digital filter used in the digital filter processing executed in the high-speed analog unit 5 and the filter characteristics of the digital filter in the setting are displayed.

In the example shown in FIG. 4, firstly, four channels (Ch1, Ch2, Ch3, Ch4) can be set as channels (a display area 303). By selecting any one of Ch1, Ch2, Ch3 and Ch4 in channel selection tabs shown on the display area 303, the filter characteristics of this channel are displayed.

In addition, the digital filter processing function that can be executed in the high-speed analog unit 5, that is, any one of a low-pass filter function, a moving-average filter function and a function combining the two can be selected (a display area 304). By selecting any one of graph type selection tabs shown on the display area 304, any one of the low-pass filter, the moving-average filter, and the combination of the low-pass filter and the moving-average filter can be selected, and the filter characteristics of the selected digital filter are displayed.

In addition, as shown on the display area 301, as the filter parameters, a sampling number (time), a sampling cycle (µs), a frequency (kHz), a cut-off frequency (Hz) of the low-pass filter, a moving-average count (time) of the moving-average filter, an operation cycle (µs) of the digital filter, and an operation frequency (Hz) of the digital filter can be set.

Furthermore, on the display area 302, as the filter characteristics of the digital filter, the graph showing the attenuation characteristic and the graph showing the step response time are displayed.

In addition, the task cycle of the fixed-cycle task may be displayed. In the example shown in FIG. 4, it is displayed on the upper part of the display area 301 that the task cycle of the fixed-cycle task is 1 ms.

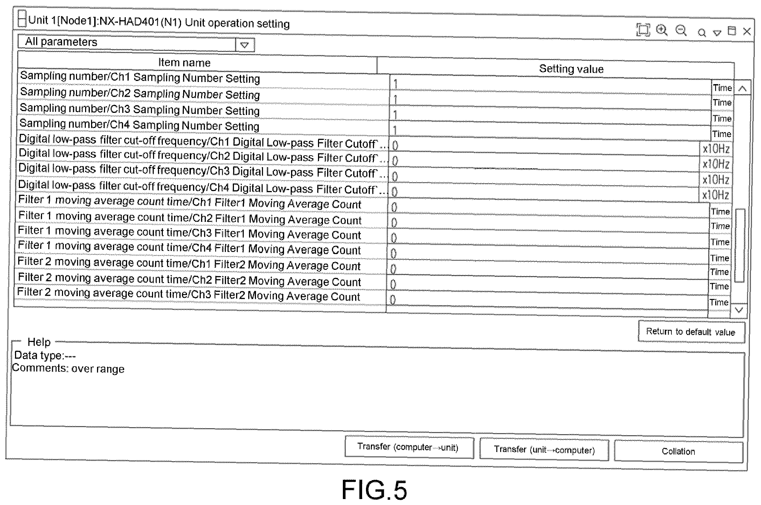

In FIG. 5, a screen example in which the finally decided filter parameters are set in the high-speed analog unit 5 is shown. When the user who has confirmed the filter characteristics shown in FIG. 4 determines that there is no problem and the filter parameters are decided, a screen that can confirm the set filter parameters as shown in FIG. 5 is displayed. Then, when a "transfer (computer→unit)" button shown in FIG. 5 is pressed, the displayed filter parameters are output to the high-speed analog unit 5, and the filter parameters of the digital filter processing executed by the high-speed analog unit 5 are set.

In addition, when a "transfer (unit→computer)" button is pressed, the digital filter setting device 1 acquires the filter parameters set at that point from the high-speed analog unit 5.

In addition, when a "collation" button is pressed, the digital filter setting device 1 collates the filter parameters on a screen in the digital filter setting device 1 (that is, the filter parameters in the software for setting the filter parameters) and the filter parameters set by the high-speed analog unit 5, and performs a display demonstrating the filter parameters of different values.

### [Display example of filter characteristics]

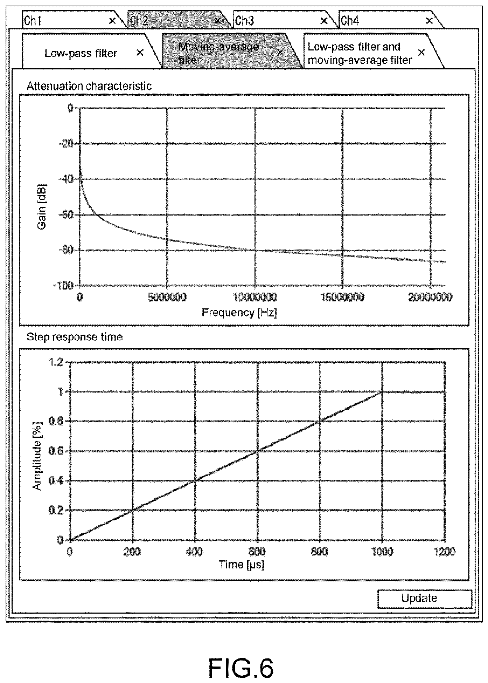

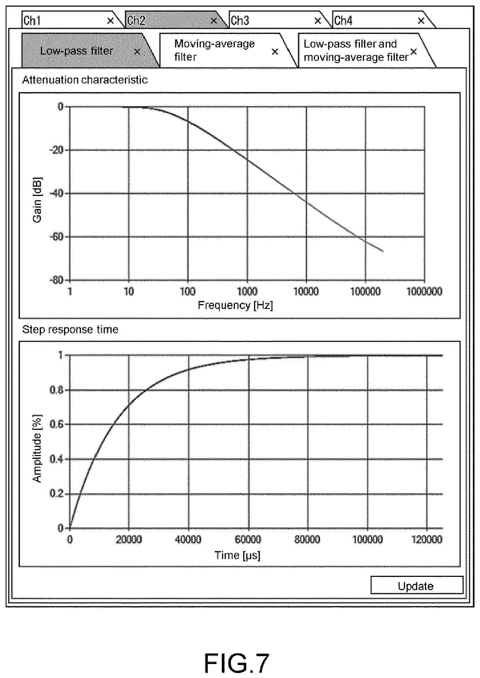

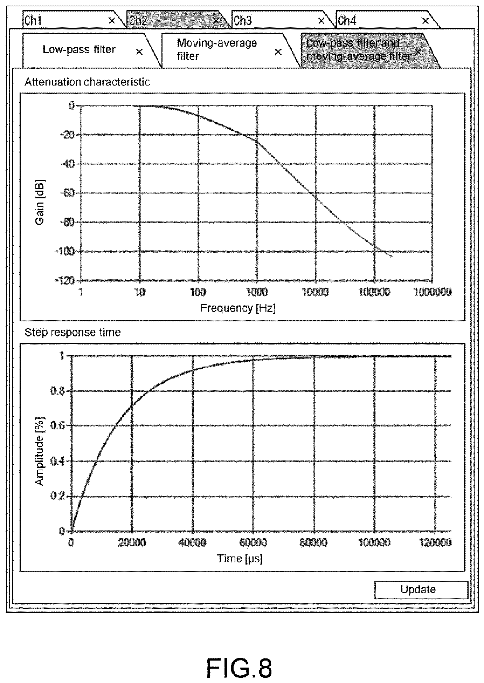

Next, with reference to FIGs. 6-8, a display example of filter characteristics is described. FIGs. 6-8 are drawings showing examples of the filter characteristics displayed by the digital filter setting device 1. In FIG. 6, the filter characteristics (the attenuation characteristic, the step response time) in a case of using the moving-average filter as the digital filter are shown. In FIG. 7, the filter characteristics (the attenuation characteristic, the step response time) in a case of using the low-pass filter as the digital filter are shown. In addition, in FIG. 8, the filter characteristics (the attenuation characteristic, the step response time) in a case of using the combination of the low-pass filter and the moving-average filter as the digital filter are shown.

The filter characteristics shown in FIG. 8 are filter characteristics in the case of using the combination of the low-pass filter and the moving-average filter as the digital filter, and thus is a sum of the filter characteristics in the case of using the moving-average filter shown in FIG. 6 and the filter characteristics in the case of using the low-pass filter shown in FIG. 7.

In addition, as described above, the filter characteristics shown in FIGs. 6-8 can be switched by selecting any one of the graph type selection tabs.

According to this configuration, since the filter characteristics of the low-pass filter and the moving-average filter are displayed in the form of graph, the user can easily recognize the filter characteristics of each digital filter or the filter characteristics of the combination of both. Accordingly, in regard to each of the low-pass filter and the moving-average filter, the user can confirm a change degree of the characteristics resulted from the alteration of the parameters and thus can easily determine which parameter should be altered. In addition, a combined result is also displayed so that the user can also easily recognize the final characteristics resulted from the parameter alteration.

### [Implementation example using software]

A control block of the digital filter setting device 1 (especially the control part 10 (the parameter setting part 11, the graph generating part 12, the attenuation characteristic calculation part 13, and the step response time calculation part 14)) may be implemented by a logic circuit (hardware) formed in an integrated circuit (IC chip) and the like, or may be implemented by software.

In the latter case, the digital filter setting device 1 is provided with a computer that executes commands of a program which is software for implementing each function. The computer includes, for example, one or more processor and a computer readable recording medium in which the above program is stored. Besides, the processor reads the program from the recording medium and executes the program in the computer, thereby achieving the purpose of the invention. A CPU (Central Processing Unit) for example can be used as the processor. In addition to a "non-transitory tangible media" such as a ROM (Read Only Storage) and the like, a tape, a disk, a card, a semiconductor memory, a programmable logic circuit and the like can be used as the above recording medium. Besides, a RAM (Random Access Storage) and the like for deploying the program may be further provided. In addition, the program may be supplied to the computer via an optional transmission medium (a communication network or a broadcast wave or the like) capable of transmitting the program. Furthermore, one aspect of the invention can also be implemented in a form of a data signal which is embedded in a carrier wave and in which the program is embodied by an electronic transmission.

### [Description of the Symbols]

1 digital filter setting device
2 PLC (control device)
3 IO terminal
4 display input device
5 high-speed analog unit (digital filter device)
6 CPU unit
7 PLC system bus
8 communication coupler
9 IO terminal bus
10 control part
11 parameter setting part (input receiving part)
12 graph generating part (graph display part)
13 attenuation characteristic calculation part (filter characteristic calculation part)
14 step response time calculation part (filter characteristic calculation part)
20 operation receiving part
30 display part
40 output part

## Claims

1. A digital filter setting device (1) which sets filter parameters of a digital filter device (5) configured to perform a filter processing to an input analog signal by a digital filter, the digital filter setting device (1) comprises:
an input receiving part (11) configured to receive input of the filter parameters;
a filter characteristic calculation part (14) configured to calculate a step response time as a filter characteristic of the digital filter when the filter parameters received by the input receiving part (11) are set; and
a graph display part (12) configured to display the calculated step response time in a form of graph on a display part.
**characterized in that** the digital filter device (5) is included in a control device which is configured to control a control object by repeatedly executing a plurality of control programs at a prescribed time interval, and
the graph display part (12) is configured to cause a task cycle of a fixed-cycle task in the control device to be displayed along with the graph on the display part,
to indicate to a user the step response time of the digital filter to which the filter parameters are set and the rising of the analog signal, and to prevent that the I/O refresh timing is in the midway of the rising of the analog signal and the analog input, due to a delayed filtering.

2. The digital filter setting device (1) according to claim 1, wherein the filter characteristic calculation part (14) is configured to calculate an attenuation characteristic of the digital filter as the filter characteristic, and
the graph display part (12) displays the attenuation characteristic of the digital filter in the form of graph.

3. The digital filter setting device (1) according to claims 1 or 2, wherein the digital filter device (5) is configured to comprise executing processing of plural kinds of digital filters, and
the graph display part (12) is configured to display, in the form of graph, the filter characteristics of each of the plural kinds of digital filters or the filter characteristics in a combination of the plural kinds of digital filters.

4. The digital filter setting device (1) according to any one of claims 1 to 3, wherein the filter parameters comprise a cut-off frequency in a low-pass filter and a moving-average count in a moving-average filter.

5. A control method of a digital filter setting device (1) which sets filter parameters of a digital filter device (5) for performing a filter processing to an input analog signal by the digital filter, the control method comprises:
an input receiving step for receiving input of the filter parameters;
a filter characteristic calculation step for calculating a step response time as a filter characteristic of the digital filter when the filter parameters received by the input receiving part (11) are set; and
a graph display step for displaying the calculated step response time in a form of graph on a display part, **characterized in that**
the digital filter device (5) is included in a control device which controls a control object by repeatedly executing a plurality of control programs at a prescribed time interval, and
in the graph display step a task cycle of a fixed-cycle task in the control device is displayed along with the graph on the display part,
to indicate to a user the step response time of the digital filter to which the filter parameters are set and the rising of the analog signal, and to prevent that the I/O refresh timing is in the midway of the rising of the analog signal and the analog input, due to a delayed filtering

6. A control program, **characterized in that**, the control program causes a computer to function as the digital filter setting device (1) according to claim 1 and causes the computer to function as the filter characteristic calculation part (14) and the graph display part (12).

## Patentansprüche

1. Digitale Filtereinstellvorrichtung (1), die Filterparameter einer digitalen Filtervorrichtung (5) einstellt, die so konfiguriert ist, dass sie eine Filterverarbeitung an einem analogen Eingangssignal durch einen digitalen Filter durchführt, wobei die digitale Filtereinstellvorrichtung (1) umfasst:
einen Eingangsempfangsteil (11), der so konfiguriert ist, dass er die Eingabe der Filterparameter empfängt;
einen Filtercharakteristik-Berechnungsteil (14), der so konfiguriert ist, dass er eine Sprungantwortzeit als Filtercharakteristik des digitalen Filters berechnet, wenn die vom Eingangsempfangsteil (11) empfangenen Filterparameter eingestellt werden; und
ein Diagrammanzeigeteil (12), das so konfiguriert ist, dass die berechnete Sprungantwortzeit in Form eines Diagramms auf einem Anzeigeteil angezeigt wird,
**dadurch gekennzeichnet, dass** die digitale Filtereinrichtung (5) in einer Steuereinrichtung enthalten ist, die so konfiguriert ist, dass sie ein Steuerobjekt durch wiederholtes Ausführen einer Vielzahl von Steuerprogrammen in einem vorgeschriebenen Zeitintervall steuert, und
das Diagrammanzeigeteil (12) so konfiguriert ist, dass ein Aufgabenzyklus einer Aufgabe mit festem Zyklus in der Steuervorrichtung zusammen mit dem Diagramm auf dem Anzeigeteil angezeigt wird, um einem Benutzer die Sprungantwortzeit des digitalen Filters, auf die die Filterparameter eingestellt sind, und den Anstieg des Analogsignals anzuzeigen und zu verhindern, dass die E/A-Aktualisierungszeit aufgrund einer verzögerten Filterung in der Mitte des Anstiegs des Analogsignals und des Analogeingangs liegt.

2. Die Digitale Filtereinstellvorrichtung (1) nach Anspruch 1, wobei der Filtercharakteristik-Berechnungsteil (14) so konfiguriert ist, dass er eine Dämpfungscharakteristik des Digitalfilters als Filtercharakteristik berechnet, und
der Diagrammanzeigeteil (12) zeigt die Dämpfungscharakteristik des digitalen Filters in Form eines Diagramms an.

3. Die digitale Filtereinstellvorrichtung (1) nach Anspruch 1 oder 2, wobei die digitale Filtervorrichtung (5) so konfiguriert ist, dass sie die Ausführung der Verarbeitung mehrerer Arten von digitalen Filtern umfasst, und
der Diagrammanzeigeteil (12) so konfiguriert ist, dass er die Filtercharakteristiken jedes der mehreren Arten von Digitalfiltern oder die Filtercharakteristiken in einer Kombination der mehreren Arten von Digitalfiltern in Form eines Diagramms anzeigt.

4. Die Digitale Filtereinstellvorrichtung (1) nach einem der Ansprüche 1 bis 3, wobei die Filterparameter eine Grenzfrequenz in einem Tiefpassfilter und eine gleitende Mittelwertzählung in einem gleitenden Mittelwertfilter umfassen.

5. Ein Steuerverfahren einer digitalen Filtereinstellvorrichtung (1), die Filterparameter einer digitalen Filtervorrichtung (5) zur Durchführung einer Filterverarbeitung eines analogen Eingangssignals durch das digitale Filter einstellt, **dadurch gekennzeichnet, dass** das Steuerverfahren umfasst:
einen Eingangsempfangsschritt zum Empfangen der Eingabe der Filterparameter;
einen Filtercharakteristik-Berechnungsschritt zum Berechnen einer Sprungantwortzeit als Filtercharakteristik des digitalen Filters, wenn die vom Eingangsempfangsteil (11) empfangenen Filterparameter eingestellt sind; und
einen Graphen-Anzeigeschritt zum Anzeigen der berechneten Sprungantwortzeit in Form eines Graphen auf einem Anzeigeteil, **dadurch gekennzeichnet, dass**
die digitale Filtervorrichtung (5) in einer Steuervorrichtung enthalten ist, die ein Steuerobjekt durch wiederholtes Ausführen einer Vielzahl von Steuerprogrammen in einem vorgeschriebenen Zeitintervall steuert, und
im Schritt der Diagrammanzeige wird ein Aufgabenzyklus einer Aufgabe mit festem Zyklus im Steuergerät zusammen mit dem Diagramm auf dem Anzeigeteil angezeigt, um einem Benutzer die Sprungantwortzeit des digitalen Filters, auf die die Filterparameter eingestellt sind, und den Anstieg des Analogsignals anzuzeigen und zu verhindern, dass die E/A-Aktualisierungszeit aufgrund einer verzögerten Filterung in der Mitte des Anstiegs des Analogsignals und des Analogeingangs liegt.

6. Ein Steuerprogramm, **dadurch gekennzeichnet, dass** das Steuerprogramm einen Computer als die digitale Filtereinstellvorrichtung (1) nach Anspruch 1 und den Computer als den Filtercharakteristik-Berechnungsteil (14) und den Diagrammanzeigeteil (12) arbeiten lässt.

## Revendications

1. Dispositif de réglage de filtre numérique (1) qui règle des paramètres de filtre d'un dispositif de filtre numérique (5) configuré pour réaliser un traitement de filtrage sur un signal analogique d'entrée par un filtre numérique, le dispositif de réglage de filtre numérique (1) comprend :
une partie de réception d'entrée (11) configurée pour recevoir une entrée des paramètres de filtre ;
une partie de calcul de caractéristique de filtre (14) configuré pour calculer un temps de réponse indiciel en tant que caractéristique de filtre du filtre numérique lorsque les paramètres de filtre reçus par la partie de réception d'entrée (11) sont réglés ; et
une partie d'affichage de graphe (12) configurée pour afficher le temps de réponse indiciel calculé sous la forme d'un graphe sur une partie d'affichage,
**caractérisé par le fait que** le dispositif de filtre numérique (5) est compris dans un dispositif de commande qui est configuré pour commander un objet de commande par exécution répétée d'une pluralité de programmes de commande à un intervalle de temps prescrit, et
la partie d'affichage de graphe (12) est configurée pour amener un cycle de tâche d'une tâche à cycle fixe du dispositif de commande à être affiché conjointement avec le graphe sur la partie d'affichage,
pour indiquer à un utilisateur le temps de réponse indiciel du filtre numérique pour lequel les paramètres de filtre sont réglés et la montée du signal analogique, et pour empêcher que la synchronisation de rafraîchissement d'entrée/sortie ne soit à mi-chemin de la montée du signal analogique et de l'entrée analogique, en raison d'un filtrage différé.

2. Dispositif de réglage de filtre numérique (1) selon la revendication 1, dans lequel la partie de calcul de caractéristique de filtre (14) est configurée pour calculer une caractéristique d'atténuation du filtre numérique en tant que caractéristique de filtre, et
la partie d'affichage de graphe (12) affiche la caractéristique d'atténuation du filtre numérique sous la forme d'un graphe.

3. Dispositif de réglage de filtre numérique (1) selon la revendication 1 ou 2, dans lequel le dispositif de filtre numérique (5) est configuré pour comprendre l'exécution d'un traitement de plusieurs types de filtres numériques, et
la partie d'affichage de graphe (12) est configurée pour afficher, sous la forme d'un graphe, les caractéristiques de filtre de chacun des différents types de filtres numériques ou les caractéristiques de filtre d'une combinaison des différents types de filtres numériques.

4. Dispositif de réglage de filtre numérique (1) selon l'une quelconque des revendications 1 à 3, dans lequel les paramètres de filtre comprennent une fréquence de coupure d'un filtre passe-bas et un compte de moyenne mobile d'un filtre à moyenne mobile.

5. Procédé de commande d'un dispositif de réglage de filtre numérique (1) qui règle des paramètres de filtre d'un dispositif de filtre numérique (5) pour réaliser un traitement de filtrage sur un signal analogique d'entrée par le filtre numérique, le procédé de commande comprend :
une étape de réception d'entrée pour recevoir une entrée de paramètres de filtre ;
une étape de calcul de caractéristique de filtre pour calculer un temps de réponse indiciel en tant que caractéristique de filtre du filtre numérique lorsque les paramètres de filtre reçus par la partie de réception d'entrée (11) sont réglés ; et
une étape d'affichage de graphe pour afficher le temps de réponse indiciel calculé sous la forme d'un graphe sur une partie d'affichage, **caractérisé par le fait que**
le dispositif de filtre numérique (5) est compris dans un dispositif de commande qui commande un objet de commande par exécution répétée d'une pluralité de programmes de commande à un intervalle de temps prescrit, et
au cours de l'étape d'affichage de graphe, un cycle de tâche d'une tâche à cycle fixe du dispositif de commande est affiché conjointement avec le graphe sur la partie d'affichage,
pour indiquer à un utilisateur le temps de réponse indiciel du filtre numérique pour lequel les paramètres de filtre sont réglés et la montée du signal analogique, et pour empêcher que la synchronisation de rafraîchissement d'entrée/sortie ne soit à mi-chemin de la montée du signal analogique et de l'entrée analogique, en raison d'un filtrage différé.

6. Programme de commande, **caractérisé par le fait que** le programme de commande amène un ordinateur à fonctionner en tant que dispositif de réglage de filtre numérique (1) selon la revendication 1 et amène l'ordinateur à fonctionner en tant que partie de calcul de caractéristique de filtre (14) et partie d'affichage de graphe (12).
